# EUROPEAN PATENT APPLICATION

(11) **EP 1 843 203 A1**
(43) Date of publication of application: **10.10.2007**
(21) Application number: 06112161.2
(22) Date of filing: 03.04.2006
(51) Int. Cl.: G03F 7/20

(54) **Method of making a photopolymer printing plate**

(71) Applicant: Agfa Graphics N.V., 2640 Mortsel (BE)
(72) Inventor: Van Damme, Marc, 2640, Mortsel (BE); Marland, Fred, William, Massachusetts (US); van Hunsel, John c/o Agfa Graphics NV, IP Dept. 3622, B-2640 Mortsel (BE); Sagan, Stephen, 02420 Lexington, Massachusetts (US); Platz, Torsten, 02139 Cambridge, Massachusetts (US)
(74) Representative: Goedeweeck, Rudi

(57) **Abstract**

1. A method for making a lithographic printing plate comprising the steps of:
- providing a printing plate precursor comprising a support and a photosensitive coating wherein said photosensitive coating comprises a photopolymerizable composition;
- image wise exposing said printing plate precursor on an external drum apparatus emitting one or more scanning laser beams having a wavelength between 390 and 420 nm and an energy density, measured on the surface of the precursor, of 100 µJ/cm² or less.
- optionally pre-heating said printing plate precursor;
- processing said exposed printing plate precursor with a developer.

## Description

### FIELD OF THE INVENTION

The present invention relates to a method of making a lithographic printing plate.

### BACKGROUND OF THE INVENTION

In lithographic printing, a so-called printing master such as a printing plate is mounted on a cylinder of the printing press. The master carries a lithographic image on its surface and a printed copy is obtained by applying ink to said image and then transferring the ink from the master onto a receiver material, which is typically paper. In conventional, so-called 'wet' lithographic printing, ink as well as an aqueous fountain solution (also called dampening liquid) are supplied to the lithographic image which consists of oleophilic (or hydrophobic, i.e. ink-accepting, water-repelling) areas as well as hydrophilic (or oleophobic, i.e. water-accepting, ink-repelling) areas. In so-called 'driographic' printing, the lithographic image consists of ink-accepting and ink-abhesive (ink-repelling) areas and during driographic printing, only ink is supplied to the master.

Printing masters are generally obtained by the so-called computer-to-film (CtF) method wherein various pre-press steps such as typeface selection, scanning, color separation, screening, trapping, layout and imposition are accomplished digitally and each color selection is transferred to graphic arts film using an imagesetter. After processing, the film can be used as a mask for the exposure of an imaging material called plate precursor and after plate processing, a printing plate is obtained which can be used as a master. Since about 1995, the so-called 'computer-to-plate' (CtP) method has gained a lot of interest. This method, also called 'direct-to-plate', bypasses the creation of film because the digital document is transferred directly to a plate precursor by means of a so-called plate-setter. A plate precursor for CtP is often called a digital plate.

Digital plates can roughly be divided in three categories : (i) silver plates, which work according to the silver salt diffusion transfer mechanism; (ii) photopolymer plates which contain a photopolymerizable composition that hardens upon exposure to light and (iii) thermal plates of which the imaging mechanism is triggered by heat or by light-to-heat conversion. Thermal plates are mainly sensitized for infrared lasers emitting at 830 nm or 1064 nm. Typical photopolymer plates are sensitized for visible light, mainly for exposure by an Ar laser (488 nm) or a FD-YAG laser (532 nm).

The wide-scale availability of low cost blue or violet laser diodes, originally developed for data storage by means of DVD, has enabled the production of plate-setters operating at shorter wavelength. More specifically, semiconductor lasers emitting from 350 to 450 nm have been realized using an InGaN material. An advantage of violet plate-setters, compared to visible light plate-setters, are the improved safe-light conditions. Laser diodes, emitting violet light with a wavelength around 405 nm (± 15 nm) are at present the most important, commercially available, violet laser diodes.

Photopolymer plates sensitized for the wavelength range from 350 to 450 nm have also been described in the prior art. Photopolymer plates generally contain a polymerizable monomer, a binder, a photoinitiator and a sensitizing dye. EP-A 985 683 describes a composition comprising a titanocene compound as photoinitiator and specific dyes as sensitizers for the wavelength range from 350 to 450 nm. EP-A 1 035 435 discloses a 1,3-dihydro-1-oxo-2H-indene derivative as sensitizing dye. EP-A 1 048 982 and EP-A 1 070 990 also disclose certain dyes in combination with a titanocene photoinitiator. A wide range of dyes for the wavelength range from 300 to 1200 nm is disclosed in EP-A 1091247.

To enable short exposure times with the commercially available blue or violet laser diodes, resulting in a higher throughput (i.e. higher numbers of printing plate precursors that can be exposed in a given time interval) there is a need to increase the sensitivity of the violet sensitive photopolymerizable compositions. EP-A 1 349 006 and WO2005/029187 disclose a photopolymerizable composition using optical brightheners as sensitizers, which can be exposed with violet laser diodes. In EP-A 1 621 928 a composition is disclosed which is photopolymerizable upon absorption of light in the wavelength range from 300 to 450 nm, the composition comprising a binder, a polymerizable compound, a sensitizer and a photoinitiator, wherein the sensitizer is a fluorene compound that is conjugated via a double or triple bond with an aromatic or heteroaromatic group. The photopolymerizable compositions described in EP-A 1 349 006, WO2005/029187 and EP-A 1 621 928 can be exposed with violet light with an energy density, measured on the surface of the plate, of 100 µJ/cm² or less.

Three major categories of plate-setters, i.e. apparatuses wherein the lithographic printing plates are image-wise exposed with a laser beam, are known: flat bed, internal drum (ITD) and external drum (XTD) type plate-setters. At present the majority of commercially available violet plate-setters on the market are of the flat bed or internal drum type.

WO2005/111717 discloses an image recording method, comprising imagewise exposing a photopolymerizable lithographic printing plate precursor with an imaging time per pixel of 1 milliseconds or less using a laser light with an emission wavelength of from 250 nm to 420 nm.

US2006/0001849 describes an apparatus for exposing a lithographic printing plate, said apparatus comprising an imaging head comprising a plurality of laser diodes emitting light of a wavelength between 350 nm and 450 nm. Since each spot on the lithographic printing plate to be exposed receives light, emitted from a plurality of laser diodes, low power laser diodes can be used.

US2005/0214687 discloses a method comprising the steps of exposing, with an ultraviolet laser, a printing plate precursor comprising at least one polymerization initiator selected from an arene-iron complex and a tribromoacetyl compound, a polymerizable ethylenically unsaturated compound and an alkali soluble resin with an acid value of 5 to 200, followed by development in an aqueous alkaline solution.

There is a continuous need to improve the overall image quality and consistency of lithographic printing plates obtained from high speed violet sensitive photopolymerizable printing plate precursors. Especially for high throughput applications, resulting in a low energy density, measured on the surface of the plate (e.g. 100 µJ/cm² or less), a need to further improve the image quality and consistency exists.

Typically, a photopolymer plate is processed in alkaline developers having a pH > 9. To simplify or even avoid such a development in alkaline solution WO-2005/111727 discloses a method wherein a photopolymerizable printing plate precursor can be, after image wise exposure, developed in a so called gum solution. In WO-2005/111717 the photopolymerizable printing plate precursor is developed on press by applying ink and/or fountain to the exposed printing plate precursor. In the unpublished EP-A 5 111 025 (filed on 2005-11-21) the photopolymerizable printing plate precursor, after exposure, is first developed in water to remove the topcoat, followed by a further development on press by applying ink and/or fountain to the plate.

### SUMMARY OF THE INVENTION

It is an object of this invention to provide a method of preparing a lithographic printing plate with a violet plate-setter, operating at low exposure levels of 100 µJ/cm² or less, characterized by a high image quality and an improved exposure latitude of the obtained printing plate. The ability to operate at low exposure levels enables a high throughput while realizing printing plates with a very good image quality.

The improved exposure latitude results in a good image quality at different low exposure levels. This improved exposure latitude reduces the need to measure the exposure levels, to adjust if necessary, and in the worse case to remake the plates. This again improves the throughput of the plate-setter device.

These objectives are obtained by the method described in claim 1. Other specific embodiments of this invention are described in the dependant claims.

### BRIEF DESCRIPTION OF THE DRAWINGS

Figure 1 shows schematically an example of a conceptual External Drum (XTD) exposure set up used in the present invention.
Figure 2 shows the exposure latitude of the Invention Example 3 and the Comparative Example 3.

### DETAILED DESCRIPTION OF THE INVENTION

### Method of exposure

The inventive image recording method to prepare lithographic printing plates, characterized by a very good image quality and exposure latitude, comprises the steps as described in claim 1.

The plate-setter used in the method of this invention is an External Drum (XTD) plate-setter. In an XTD plate-setter the printing plate precursor is mounted on the outside surface of a rotating drum and exposed by a light source traveling axially along the outer surface of the drum. Optionally the print cylinder of the printing press itself can constitute the drum of the imaging apparatus.

The wavelength of the light source used in the present invention is between 390 nm and 420 nm. In principle any light source, emitting in the wavelength region 390 nm - 420 nm can be used. Preferred light sources are laser light sources, e.g. gas lasers, solid state lasers or semiconductor lasers. More preferred light sources are laser diodes, highly preferred commercially available InGaN-based semiconductor laser diodes having a wavelength of 405 nm. The power of the laser diodes may be between 5 and 200 mW, preferably between 20 mW and 150 mW, most preferably between 50 mW and 80 mW. One laser diode may be used to expose the lithographic printing plate precursors, but also multiple laser diodes may be used.

The energy density, measured on the surface of the precursor, is 100 µJ/cm² or less, more preferably 80 µJ/cm² or less, most preferably 70 µJ/cm² or less.

The light emitted by the laser source is typically modulated by an optical system before it reaches the lithographic printing plate precursor, mounted on the rotating drum. Modulation is done according to a digital information signal representing data corresponding to the image to be recorded. Some optical systems can modulate the laser light from the laser diode(s) to produce multiple individually addressable writing beams. Known optical systems that can be used are based on the DMD (Digital Mirror Device) or GLV (Grating Light Valve) technology. The present invention preferably uses a GLV based optical system, as described in US 6,229,650, to produce multiple individually addressable writing beams from the laser light, emitted from one or more laser diodes, as described in US 7,012,766 and US 6,433,934. A highly preferred embodiment of this invention uses a GLV based optical system to produce individually addressable writing beams from the laser light, emitted from two or more laser diodes. The number of individually addressable beams, modulated by the optical system and used to expose the lithographic printing plate, mounted on the rotating drum, may vary between 100 and 1088, more preferably between 250 and 1024. A large number of beams ensures a fast writing speed at relatively low drum rotational speed, simplifying operation and ensuring a long-term reliability. The multiple beams may be automatically calibrated by sensors to ensure optimal and uniform exposure.

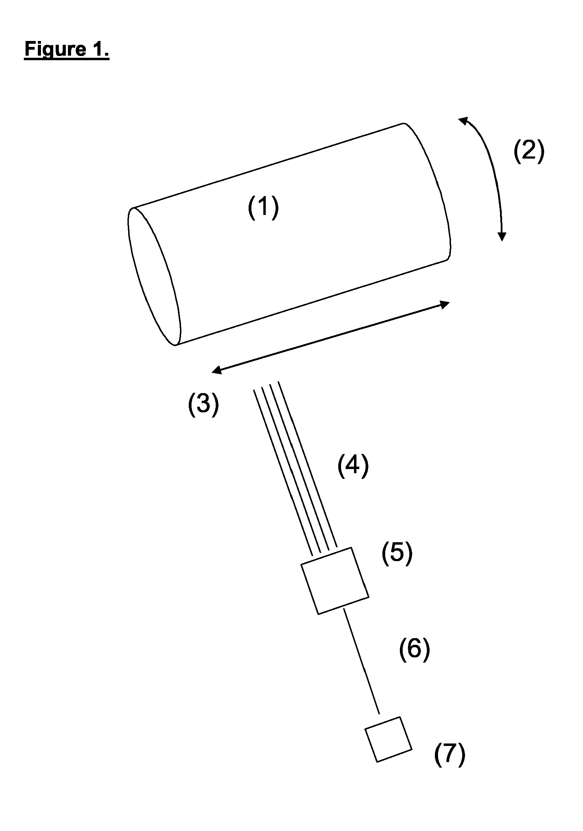

Figure 1. shows schematically an example of a conceptual XTD exposure set up. The laser light (6) from one or more laser diodes (7) is modulated by an optical modulating system, e.g. a GLV optical system (5). The optical system (5) produces, from the laser light, multiple individually addressable writing beams (4). These multiple writing beams are used to expose the lithographic printing plate precursor, mounted on the external surface of a rotating drum (1).

Many clamping systems are described for holding the printing plate on the external drum, e.g. the systems described in US 6,412,413, US 6,705,226 and the unpublished EP-A 05 108 894 (filed on 27-09-2005).

The drum (1) is rotating at a predetermined constant speed in a predetermined direction (i.e. fast scan direction) (2). During image-wise exposure the movable optical system (5) is translated in a slow scan direction (i.e. cross scan direction)(3) while the cylindrical drum, with recording media mounted on an external surface thereof, is rotated along its longitudinal axis (2). The drum rotation causes the recording media to advance past the image recording source along a fast scan direction (2) that is substantially perpendicular to the slow scan direction (3).

The imaging time per pixel (pixel dwell time) is determined by the rotating speed of the drum, i.e. drum speed (rotation per minute, rpm). Preferred pixel dwell times according to the present invention are between 0.5 µs and 50 µs, more preferably between 1.0 µs and 15 µs, most preferably between 2.0 µs and 10 µs.

The contrast ratio (i.e. the ratio between the light intensity falling on an image-pixel and the light intensity falling on a non-image pixel) of the exposing device is preferably greater then 150, more preferably greater then 250, and most preferably greater then 500.

The spot of the writing beams can have a Gaussian shape or a more rectangular shape, the latter being preferably used. The size of the more rectangular shaped spot in the cross scan direction must be in accordance with the exposure grid, i.e. the number of dots per inch. For an exposure grid of 2400 dots per inch (dpi) the spot size in the cross scan direction is therefore preferably around 10.5 µm. The spot size in the fast scan direction is preferably between 2.5 and 25 µm, more preferably bewteen 2.5 and 15 µm, most preferably between 5.0 and 10 µm.

### Lithographic printing plate precursor.

The lithographic printing plate precursor used in the method of this invention comprises a photosensitive coating on a support. Said coating comprises preferably at least one layer comprising a photopolymerizable composition, said layer hereinafter also referred to as "photopolymerizable layer". Said coating may further comprise an oxygen-barrier layer, which comprises a water-soluble or water-swellable polymer, on said photopolymerizable layer, said barrier layer hereinafter also referred to as "toplayer" or "overcoat" or "overcoat layer". Said coating may further comprise an intermediate layer between the photopolymerizable layer and the support. The thickness of the coating preferably ranges between 0.4 and 10 g/m², more preferably between 0.5 and 5 g/m², most preferably between 0.6 and 3 g/m².

A preferred photopolymerizable layer typically comprises (i) a polymerizable compound, (ii) a polymerization initiator capable of hardening said polymerizable compound in the exposed areas and (iii) a binder. The photopolymerizable layer may further comprise an adhesion promoting compound. The photopolymerizable layer has a coating thickness preferably ranging between 0.4 and 5.0 g/m², more preferably between 0.5 and 3.0 g/m², most preferably between 0.6 and 2.2 g/m².

### Intermediate layer - adhesion promoting compound

The optional intermediate layer may comprise adhesion promoting compounds. These adhesion promoting compounds may however also be incorporated in the photopolymerizable layer. The adhesion promoting compound is preferably a compound capable of interacting with said support, e.g. a compound having an addition polymerizable ethylenically unsaturated bond and a functional group capable of interacting with the support, more preferably a functional group capable of interacting with a grained and anodised aluminum support. Under "interacting" is understood each type of physical and/or chemical reaction or process whereby, between the functional group and the support, a bond is formed which can be a covalent bond, an ionic bond, a complex bond, a coordinate bond or a hydrogen-bridge bond, and which can be formed by an adsorption process, a chemical reaction, an acid-base reaction, a complex-forming reaction or a reaction of a chelating group or a ligand. The adhesion promoting compound may be selected from at least one of the low molecular weight compounds or polymeric compounds as described in EP-A 851 299 from lines 22 on page 3 to line 1 on page 4, EP-A 1 500 498 from paragraph [0023] on page 7 to paragraph [0052] on page 20, EP-A 1 495 866 paragraph [0030] on page 5 to paragraph [0049] on page 11, EP-A 1 091 251 from paragraph [0014] on page 3 to paragraph [0018] on page 20, and EP-A 1 520 694 from paragraph [0023] on page 6 to paragraph [0060] on page 19. Preferred compounds are those compounds which comprise a phosphate or phosphonate group as functional group capable of adsorbing on the aluminum support and which comprise an addition-polymerizable ethylenic double bond reactive group, especially those described in EP-A 851 299 from lines 22 on page 3 to line 1 on page 4 and EP-A 1 500 498 from paragraph [0023] on page 7 to paragraph [0052] on page 20. Also preferred are those compounds comprising tri-alkyl-oxy silane groups, hereinafter also referred to as "trialkoxy silane" groups, wherein the alkyl is preferably methyl or ethyl, or wherein the trialkyloxy silane groups are at least partially hydrolysed to silanol groups, as functional group capable of adsorbing on the support, especially silane coupling agents having an addition-polymerizable ethylenic double bond reactive group as described in EP-A 1 557 262 paragraph [0279] on page 49 and EP-A 1 495 866 paragraph [0030] on page 5 to paragraph [0049] on page 11. The adhesion promoting compound may be present in the photopolymerizable layer in an amount ranging between 1 and 50 wt%, preferably between 3 and 30 wt%, more preferably between 5 and 20 wt% of the non-volatile components of the composition. The adhesion promoting compound may be present in the intermediate layer in an amount of at least 50 wt%, preferably at least 80 wt%, more preferably at least 90 wt%, most preferably 100 wt% of the non-volatile components of the composition. The optionally intermediate layer has a coating thickness preferably ranging between 0.001 and 1.5 g/m², more preferably between 0.003 and 1.0 g/m², most preferably between 0.005 and 0.7 g/m²

### Polymerizable compound + initiator.

The photopolymerizable composition typically comprises one or more polymerizable compounds and one or more initiator compounds. Upon image-wise exposure, the initiator system initiates crosslinking and/or polymerization of the polymerizable compounds. Initiators which are preferably used in the present invention are compounds generating radicals upon exposure, preferably upon exposure with light having a wavelength between 350 and 450 nm, more preferably between 390 and 420 nm, when used alone or in combination with suitable sensitizing agents.

According to one embodiment of the present invention, said polymerizable monomer or oligomer is a monomer or oligomer comprising at least one epoxy or vinyl ether functional group and said initiator is a Bronsted acid generator capable of generating free acid, optionally in the presence of a sensitizer, upon exposure, hereinafter said initiator also referred to as "cationic photoinitiator" or "cationic initiator".

Suitable polyfunctional epoxy monomers include, for example, 3,4-epoxycyclohexylmethyl-3,4-epoxycyclohexane carboxylate, bis-(3,4 -epoxycyclohexymethyl) adipate, difunctional bisphenol epichlorohydrin epoxy resin and multifunctional epichlorohydrintetraphenylol ethane epoxy resin.

Suitable cationic photoinitiators include, for example, triarylsulfonium hexafluoroantimonate, triarylsulfonium hexafluorophosphate, diaryliodonium hexafluoroantimonate, and haloalkyl substituted s-triazine. It is noted that most cationic initiators are also free radical initiators because, in addition to generating Bronsted acid, they also generate free radicals during photo or thermal decomposition.

According to a more preferred embodiment of the present invention, said polymerizable monomer or oligomer is a ethylenically unsaturated compound, having at least one terminal ethylenic group, hereinafter also referred to as "free-radical polymerizable monomer", and said initiator is a compound, capable of generating free radicals, optionally in the presence of a sensitizer, upon exposure, hereinafter said initiator also referred to as "free radical initiator".

Suitable free-radical polymerizable monomers include, for example, multifunctional (meth)acrylate monomers (such as (meth)acrylate esters of ethylene glycol, trimethylolpropane, pentaerythritol, ethoxylated ethylene glycol and ethoxylated trimethylolpropane, multifunctional urethanated (meth)acrylate, and epoxylated (meth)acrylate), and oligomeric amine diacrylates. The (meth)acrylic monomers may also have other double bond or epoxide group, in addition to (meth)acrylate group. The (meth)acrylate monomers may also contain an acidic (such as carboxylic acid) or basic (such as amine) functionality.

Any free radical initiator capable of generating free radicals, directly or in the presence of a sensitizer, upon exposure can be used as a free radical initiator of this invention. Suitable free-radical initiators include, for example, the derivatives of acetophenone (such as 2,2-dimethoxy-2-phenylacetophenone, and 2-methyl-1-[4-(methylthio) phenyl-2-morpholino propan-1-one); benzophenone; benzil; ketocoumarin (such as 3-benzoyl-7-methoxy coumarin and 7-methoxy coumarin); xanthone; thioxanthone; benzoin or an alkyl-substituted anthraquinone; onium salts (such as diaryliodonium hexafluoroantimonate, diaryliodonium triflate,(4-(2-hydroxytetradecyl-oxy)-phenyl) phenyliodonium hexafluoroantimonate, triarylsulfonium hexafluorophosphate, triarylsulfonium p-toluenesulfonate, (3-phenylpropan-2-onyl) triaryl phosphonium hexafluoroantimonate, and N-ethoxy(2-methyl)pyridinium hexafluorophosphate, and onium salts as described in U.S. Pat.Nos. 5,955,238, 6,037,098 and 5,629,354); borate salts (such as tetrabutylammonium triphenyl(n-butyl)borate, tetraethylammonium triphenyl(n-butyl)borate, diphenyliodonium tetraphenylborate, and triphenylsulfonium triphenyl(n-butyl)borate, and borate salts as described in U.S. Pat. Nos. 6,232,038 and 6,218,076); haloalkyl substituted s-triazines (such as 2,4-bis(trichloromethyl)-6-(p-methoxy-styryl)-s-triazine, 2,4-bis(trichloromethyl)-6-(4-methoxynaphth-1-yl)-s-triazine, 2,4-bis(trichloromethyl)-6-piperonyl-s-triazine, and 2,4-bis(trichloromethyl)-6-[(4-ethoxy-ethylenoxy)-phen-1-yl]-s-triazine, and s-triazines as described in U.S. Pat. Nos. 5,955,238, 6,037,098, 6,010,824 and 5,629,354); and titanocene (bis(etha 9-2,4-cyclopentadien-1-yl) bis[2,6-difluoro-3-(1H-pyrrol-1-yl)phenyl) titanium). Onium salts, borate salts, and s-triazines are preferred free radical initiators. Diaryliodonium salts and triarylsulfonium salts are preferred onium salts. Triarylalkylborate salts are preferred borate salts. Trichloromethyl substituted s-triazines are preferred s-triazines.

In a preferred embodiment of the present invention the photopolymerizable composition according to the present invention comprises a hexaaryl-bisimidazole (HABI; dimer of triaryl-imidazole) compound as a photopolymerization initiator alone or in combination with further photoinitiators.

A procedure for the preparation of hexaarylbisimidazoles is described in DE 1470 154 and their use in photopolymerizable compositions is documented in EP 24 629, EP 107 792, US 4,410,621, EP 215 453 and DE 3 211 312. Preferred derivatives are e. g. 2,4,5,2',4',5'-hexaphenylbisimidazole, 2,2'-bis(2-chlorophenyl)-4,5,4',5'-tetraphenylbisimidazole, 2,2'-bis(2-bromophenyl)-4,5,4',5'-tetraphenylbisimidazole, 2,2'-bis(2,4-dichlorophenyl)-4;5,4',5'-tetraphenylbisimidazole, 2,2'-bis(2-chlorophenyl)-4,5,4',5'-tetrakis(3-methoxyphenyl)bisimidazole, 2,2'-bis(2-chlorophenyl)-4,5,4',5'-tetrakis(3,4,5-trimethoxyphenyl)-bisimidazole, 2,5,2',5'-tetrakis(2-chlorophenyl)-4,4'-bis(3,4-dimethoxyphenyl)bisimidazole, 2,2'-bis(2,6-dichlorophenyl)-4,5,4',5'-tetraphenylbisimidazole, 2,2'-bis(2-nitrophenyl)-4,5,4',5'-tetraphenylbisimidazole, 2,2'-di-o-tolyl-4,5,4',5'-tetraphenylbisimidazole, 2,2'-bis(2-ethoxyphenyl)-4,5,4',5'-tetraphenylbisimidazole and 2,2'-bis(2,6-difluorophenyl)-4,5,4',5'-tetraphenylbisimidazole. The amount of the HABI photoinitiator typically ranges from 0.01 to 30 % by weight, preferably from 0.5 to 20 % by weight, relative to the total weight of the non volatile components of the photopolymerizable composition.

A very high sensitivity can be obtained in the context of the present invention by the combination of an optical brightener as sensitizer and a hexaarylbisimidazole as photoinitiator.

Suitable classes of photoinitiators other than hexaarylbisimidazole compounds include aromatic ketones, aromatic onium salts, organic peroxides, thio compounds, ketooxime ester compounds, borate compounds, azinium compounds, metallocene compounds, active ester compounds and compounds having a carbon-halogen bond, but preferably the composition comprises a non-boron comprising photopolymerization initiator and particularly preferred the photopolymerization initiator comprises no boron comopound. Many specific examples of photoinitiators suitable for the present invention can be found in EP-A 1 091 247. Other preferred initiators are trihalo methyl sulphones.

Preferably hexaarylbisimidazole compounds and/or metallocene compounds are used alone or in combination with other suitable photoinitiators, in particular with aromatic ketones, aromatic onium salts, organic peroxides, thio compounds, ketoxime ester compounds, azinium compounds, active ester compounds or compounds having a carbon halogen bond.

In a preferred embodiment of the present invention the hexaarylbisimidazole compounds make more than 50 mol-%, preferably at least 80 mol-% and particularly preferred at least 90 mol-% of all the photoinitiators used in the photopolymerizable composition of the present invention.

According to another embodiment of the present invention, said polymerizable monomer or oligomer may be a combination of a monomer or oligomer comprising at least one epoxy or vinyl ether functional group and a polymerizable ethylenically unsaturated compound, having at least one terminal ethylenic group, and said initiator may be a combination of a cationic initiator and a free-radical initiator. A monomer or oligomer comprising at least one epoxy or vinyl ether functional group and a polymerizable ethylenically unsaturated compound, having at least one terminal ethylenic group, can be the same compound wherein the compound contains both ethylenic group and epoxy or vinyl ether group. Examples of such compounds include epoxy functional acrylic monomers, such as glycidyl acrylate. The free radical initiator and the cationic initiator can be the same compound if the compound is capable of generating both free radical and free acid. Examples of such compounds include various onium salts such as diaryliodonium hexafluoroantimonate and s-triazines such as 2,4-bis(trichloromethyl)-6-[(4-ethoxyethylenoxy)-phen-1-yl]-s-triazine which are capable of generating both free radical and free acid in the presence of a sensitizer.

The photopolymerizable composition may also comprise a multifunctional monomer. This monomer contains at least two functional groups selected from an ethylenically unsaturated group and/or an epoxy or vinyl ether group. Particular multifunctional monomers for use in the photopolymer coating are disclosed in US 6,410,205, US 5,049,479, EP 1 079 276, EP 1 369 232, EP 1 369 231, EP 1 341 040, US 2003/0124460, EP 1 241 002, EP 1 288 720 and in the reference book including the cited refences: Chemistry & Technology UV & EB formulation for coatings, inks & paints - Volume 2 -Prepolymers andReactive Diluents for UV and EB Curable Formulations by N.S. Allen, M.A. Johnson, P.K.T. Oldring, M.S. Salim - Edited by P.K.T. Oldring - 1991 - ISBN 0 947798102. Particularly preferred are urethane (meth)acrylate multifunctional monomers, which can be used alone or in combination with other (meth)acrylate multifunctional monomers.

The photopolymerizable composition may also comprise a co-initiator. Typically, a co-initiator is used in combination with a free radical initiator and/or cationic initator. Particular coinitiators for use in the photopolymer coating are disclosed in US 6,410,205, US 5,049,479, EP 1 079 276, EP 1 369 232, EP 1 369 231, EP 1 341 040, US2003/0124460, EP 1 241 002, EP 1 288 720 and in the reference book including the cited refences: Chemistry & Technology UV & EB formulation for coatings, inks & paints - Volume 3 - Photoinitiators for Free Radical and Cationic Polymerisation by K.K. Dietliker - Edited by P.K.T. Oldring - 1991 - ISBN 0 947798161.

### Chain transfer agent.

In order to achieve a high sensitivity, it is advantageous to add a radical chain transfer agent as described in EP 107 792 to the composition of the present invention. The preferred chain transfer agents are sulfur-compounds especially thiols like e. g. 2-mercaptobenzothiazole, 2-mercaptobenzoxazole or 2-mercaptobenzimidazole. The amount of chain transfer agent generally ranges from 0.01 to 10 % by weight, preferably from 0.1 to 2 % by weight, relative to the total weight of the non volatile components of the photopolymerizable composition.

### Sensitizer.

To increase the sensitivity of the photopolymerizable composition towards violet light, ranging from 350 nm to 450 nm, sensitizers may be added. Preferred sensitizers, added to the photopolymerizable composition to increase the sensitivity, have an absorption spectrum between 350 nm and 450 nm, preferably between 370 nm and 420 nm, more preferably between 390 nm and 420 nm.

Sensitizers that can be used in the present invention are disclosed in e.g. EP-A 1 621 928, EP-A 1 148 387, US2006/001849, WO 2005/111717 and US 6,689,537. Particular preferred sensitizers, to achieve a high sensitivity, are the optical brighteners disclosed in EP-A 1 349 006 and WO2005/029187. The overall amount of sensitizers, disclosed in EP-A 1 349 006 and WO2005/029187, is preferably from 0.1 to 10 percent by weight with respect to the total weight of the non-volatile compounds in the photosensitive composition. For the embodiment of this invention wherein development is carried out in a gum solution the sensitizers disclosed in the unpublished EP-A 05 110 966 (filed on 2005-11-18) are particularly preferred.

### Contrast Dye.

The coating of the lithographic printing plate may further comprise a colorant. The colorant can be a dye or a pigment. After development with a gum solution or with an alkaline developer, at least part of the colorant remains in the hardened coating areas and provides a visible image, enabling an examination of the lithographic image on the developed printing plates. Preferred dyes and/or pigments are disclosed in WO 2005/111727. Highly preferred pigments are predispersed phthalocyanine. Their amount generally ranges from about 1 to 15 % by weight, preferably from about 2 to 7 % by weight, with respect to the total weight of the non-volatile compounds in the photosensitive composition. Particularly suitable predispersed phthalocyanine pigments are disclosed in DE 199 15 717 and DE 199 33 139. Preference is given to metal-free phthalocyanine pigments.

The photopolymerizable composition may also comprise compounds that undergo discoloration or coloration upon exposure with violet light. Compounds that undergo discoloration or coloration by radicals or acids, generated by the violet exposure, are preferred. Especially for the on-press processing embodiment of this invention, such compounds give rise to a print-out image enabling inspection of the image to be printed. Various dyes may be used for this purpose, e.g. diphenylmethane, triphenylmethane, thiazine, oxazine, xanthene, anthraquinone, iminoquinone, azo and azomethine dyes.

### Binder.

The photopolymerizable composition may also comprise a binder. The binder can be selected from a wide series of organic polymers. Mixtures of different binders can also be used. Useful binders include for example chlorinated polyalkylene (in particular chlorinated polyethylene and chlorinated polypropylene), polymethacrylic acid alkyl esters or alkenyl esters (in particular polymethyl (meth)acrylate, polyethyl (meth)acrylate, polybutyl (meth)acrylate, polyisobutyl (meth)acrylate, polyhexyl (meth) acrylate, poly(2-ethylhexyl) (meth)acrylate and polyalkyl (meth)acrylate copolymers of (meth) acrylic acid alkyl esters or alkenyl esters with other copolymerizable monomers (in particular with (met)acrylonitrile, vinyl chloride, vinylidene chloride, styrene and/or butadiene), polyvinyl chloride (PVC, vinylchloride/(meth)acrylonitrile copolymers, polyvinylidene chloride (PVDC), vinylidene chloride/(meth)acrylonitrile copolymers, polyvinyl acetate, polyvinyl alcohol, polyvinyl pyrrolidone, copolymers of vinyl pyrrolidone or alkylated vinyl pyrrolidone, polyvinyl caprolactam, copolymers of vinyl caprolactam, poly (meth)acrylonitrile, (meth)acrylonitrile/styrene copolymers, (meth)acrylamide/alkyl (meth)acrylate copolymers, (meth)acrylonitrile/butadiene/styrene (ABS) terpolymers, polystyrene, poly(α-methylstyrene), polyamides, polyurethanes, polyesters, methyl cellulose, ethylcellulose, acetyl cellulose, hydroxy-(C₁-C₄-alkyl)cellulose, carboxymethyl cellulose, polyvinyl formal and polyvinyl butyral. Particulary preferred binders are polymers having vinylcaprolactam, vinylpyrrolidone or alkylated vinylpyrrolidone as monomeric units. Alkylated vinylpyrrolidone polymers can be obtained by grafting alfa-olefines onto the vinylpyrrolidone polymer backbone. Typical examples of such products are the Agrimer AL Graft polymers commercially available from ISP. The length of the alkylation group may vary from C₄ to C₃₀. Other useful binders are binders containing carboxyl groups, in particular copolymers containing monomeric units of α,β-unsaturated carboxylic acids or monomeric units of α,β-unsaturated dicarboxylic acids (preferably acrylic acid, methacrylic acid, crotonic acid, vinylacetic acid, maleic acid or itaconic acid). By the term "copolymers" are to be understood in the context of the present invention as polymers containing units of at least 2 different monomers, thus also terpolymers and higher mixed polymers. Particular examples of useful copolymers are those containing units of (meth)acrylic acid and units of alkyl (meth)acrylates, allyl (meth)acrylates and/or (meth)acrylonitrile as well as copolymers containing units of crotonic acid and units of alkyl (meth)acrylates and/or (meth)acrylonitrile and vinylacetic acid/alkyl (meth)acrylate copolymers. Also suitable are copolymers containing units of maleic anhydride or maleic acid monoalkyl esters. Among these are, for example, copolymers containing units of maleic anhydride and styrene, unsaturated ethers or esters or unsaturated aliphatic hydrocarbons and the esterification products obtained from such copolymers. Further suitable binders are products obtainable from the conversion of hydroxyl-containing polymers with intramolecular dicarboxylic anhydrides. Further useful binders are polymers in which groups with acid hydrogen atoms are present, some or all of which are converted with activated isocyanates. Examples of these polymers are products obtained by conversion of hydroxyl-containing polymers with aliphatic or aromatic sulfonyl isocyanates or phosphinic acid isocyanates. Also suitable are polymers with aliphatic or aromatic hydroxyl groups, for example copolymers containing units of hydroxyalkyl (meth)acrylates, allyl alcohol, hydroxystyrene or vinyl alcohol, as well as epoxy resins, provided they carry a sufficient number of free OH groups. Particular useful binder and particular useful reactive binders are disclosed in EP 1 369 232, EP 1 369 231, EP 1 341 040, US 2003/0124460, EP 1 241 002, EP 1 288 720, US 6,027,857, US 6,171,735 and US 6,420,089.

The organic polymers used as binders have a typical mean molecular weight M_{w} between 600 and 700 000, preferably between 1 000 and 350 000. Preference is further given to polymers having an acid number between 10 to 250, preferably 20 to 200, or a hydroxyl number between 50 and 750, preferably between 100 and 500. The amount of binder(s) generally ranges from 10 to 90 % by weight, preferably 20 to 80 % by weight, relative to the total weight of the non-volatile components of the composition.

Also particular suitable binders are copolymers of vinylacetate and vinylalcohol, preferably comprising vinylalcohol in an amount of 10 to 98 mol% vinylalcohol, more preferably between 35 and 95 mol %, most preferably 40 and 75 mol %, best results are obtained with 50 to 65 mol % vinylalcohol. The ester-value, measured by the method as defined in DIN 53 401, of the copolymers of vinylacetate and vinylalcohol ranges preferably between 25 and 700 mg KOH/g, more preferably between 50 and 500 mg KOH/g, most preferably between 100 and 300 mg KOH/g. The viscosity of the copolymers of vinylacetate and vinylalcohol are measured on a 4 weight % aqueous solution at 20°C as defined in DIN 53 015 and the viscosity ranges preferably between 3 and 60 mPa.s, more preferably between 4 and 30 mPa.s, most preferably between 5 and 25 mPa.s. The average molecular weight M_{w} of the copolymers of vinylacetate and vinylalcohol ranges preferably between 5 000 and 500 000 g/mol, more preferably between 10 000 and 400 000 g/mol, most preferably between 15 000 and 250 000 g/mol. Other preferred binders are disclosed in EP 152 819 B1 on page 2 lines 50-page 4 line 20, and in EP 1 043 627 B1 on paragraph [0013] on page 3.

In another embodiment the polymeric binder comprises a hydrophobic backbone, and pendant groups including for example a hydrophilic poly(alkylene oxide) segment. The polymeric binder may also include pendant cyano groups attached to the hydrophobic backbone. A combination of such binders may also be employed. Generally the polymeric binder is a solid at room temperature, and is typically a non-elastomeric thermoplastic. The polymeric binder comprises both hydrophilic and hydrophobic regions, which is thought to be important for enhancing differentiation of the exposed and unexposed areas by facilitating developability. Generally the polymeric binder is characterized by a number average molecular weight (Mn)in the range from about 10 000 to 250 000, more commonly in the range from about 25 000 to 200 000. The polymerizable composition may comprise discrete particles of the polymeric binder. Preferably the discrete particles are particles of the polymeric binder which are suspended in the polymerizable composition. The presence of discrete particles tends to promote developability of the unexposed areas. Specific examples of the polymeric binders according to this embodiment are described in US 6,899,994, 2004/0260050, US2005/0003285, US2005/0170286 and US2005/0123853. In addition to the polymeric binder of this embodiment the imageable layer may optionally comprise one or more co-binders. Typical co-binders are water-soluble or water-dispersible polymers, such as, cellulose derivatives, poly vinyl alcohol, poly acrylic acid poly(meth)acrylic acid, poly vinyl pyrrolidone, polylactide, poly vinyl phosphonic acid, synthetic co-polymers, such as the co-polymer of an alkoxy polyethylene glycol (meth)acrylate. Specific examples of co-binders are described in US2004/0260050, US2005/0003285 and US2005/0123853. Printing plate precursors, the imageable layer of which comprises a binder and optionally a co-binder according this embodiment and described in more detail in US2004/0260050, US2005/0003285 and US2005/0123853, optionally comprises a topcoat and an interlayer.

When the development of the method as described in claim 1 is carried out in a gum solution or on press by applying ink and/or fountain solution, the photopolymerizable composition comprises preferably a polymer as described in the unpublished EP-A 05 110 943 (filed on 2005-11-18). According to this preferred embodiment said photopolymerizable layer comprises a polymer containing an acid group and a basic nitrogen-containing compound capable of neutralizing said acid group, or said photopolymerizable layer comprises a polymer containing an acid group which is neutralized by a basic nitrogen-containing compound. In accordance with this preferred embodiment said basic nitrogen-containing compound has an amino group, an amidine group or a guanidine group. Said amino group is preferably a tertiary amino group. In another preferred embodiment, said basic nitrogen-containing compound further comprises a group having an ethylenically unsaturated bond. Said group having an ethylenically unsaturated bond is most preferably a vinyl group or a (meth)acrylate group.

Examples of basic nitrogen-containing compounds are
N,N-dimethyl amino ethyl (meth)acrylate,
N,N-dimethyl amino propyl (meth)acrylate,
N,N-diethyl amino propyl (meth)acrylate,
N,N-diethyl amino ethyl (meth)acrylate,
N,N-diethyl amino propyl (meth)acrylamide,
N,N-dimethyl amino ethyl-N'-(meth)acryloyl carbamate,
N,N-diethyl amino-ethoxyethyl (meth)acrylate,
t-butyl amino ethyl (meth)acrylate,
N,N-diethyl amino ethanol,
N,N-dimethyl aniline,
N,N-dimethyl amino ethoxy ethanol,
2-amino-2-ethyl-1,3-propanediol,
tetra(hydroxy ethyl) ethylene diamine,
tetramethyl hexane diamine,
tetramethyl butane diamine,
triethanol amine,
triethyl amine,
2-N-morphorino ethanol,
2-piperidino ethanol,
N-methyl amino ethanol,
N,N-dimethyl amino ethanol,
N-ethyl amino ethanol,
N,N,N-buthyl amino diethanol,
N,N-dimethyl amino ethoxy ethanol,
N,N-diethyl amino ethoxy ethanol,
N,ethanol amine,
N,N-diethanol amine,
N,N,N-triethanol amine,
N-methyl diethanol amine,
N,N,N-tri-isopropanol amine,
N,N-dimethyl dihydroxypropyl amine,
N,N-diethyl dihydroxypropyl amine,
N-methyl-glucamine,
Piperazine,
Methylpiperazine,
N-hydroxyethylpiperazine,
N-hydroxyethylpiperazine,
N,N-dihydroxyethylpiperazine or
N-hydroxyethylpiperidine.

Of these nitrogen-containing compounds less volatile compounds are preferred to avoid odor nuisance.

Said polymer which contains an acid group is a polymer which comprises a monomeric unit having in the side chain an acid group. Said acid group is preferably a carboxylic acid group, a sulphonic acid group, an imide group or a primary (i.e. -SO₂-NH₂) or secondary (i.e. -SO₂-NH-) sulphonamide group. Said polymer which contains an acid group is preferably a polymer or copolymer of (meth)acrylic acid, maleic acid, itaconic acid or a (meth)acryl amide.

In the present invention, the basic nitrogen-containing compound may be added previously to the polymer which contains an acid group whereby the acid group is neutralised by the basic nitrogen-containing compound, resulting in the formation of a salt of the acid and the base, and this polymer is added to the solution for coating the photopolymerizable layer. In the salt formation the acid and the base are mainly ionically bond to each other. In an alternative way, the polymer which contains an acid group and the basic nitrogen-containing compound may be both added to the solution for coating the photopolymerizable layer. The ratio of the amount of basic nitrogen-containing compound to the amount of acid groups present in the polymer may vary from 1 to 100 mol %, preferably from 5 to 100 mol %, more preferably from 10 to 100 mol %, most preferably from 20 to 100 %.

### Other ingredients.

The photopolymerizable compostion may further comprise other ingredients such as for example surfactants, polymerization inhibitors, plasticizers, inorganic particles, low molecular weight hydrophilic compounds.

Preferred inhibitors for use in the photopolymer coating are disclosed in US 6,410,205, EP 1 288 720 and the unpublished patent application EP-A 04 101 955 (filed on 2004-05-06).

Various surfactants may be added to the photopolymerizable layer. Both polymeric and small molecule surfactants can be used. Nonionic surfactants are preferred. Preferred nonionic surfactants are polymers and oligomers containing one or more polyether segments (such as polyethylene glycol, polypropylene glycol, and copolymer of ethylene glycol and propylene glycol). Examples of preferred nonionic surfactants are block copolymers of propylene glycol and ethylene glycol (also called block copolymer of propylene oxide and ethylene oxide); ethoxylated or propoxylated acrylate oligomers; and polyethoxylated alkylphenols and polyethoxylated fatty alcohols. The nonionic surfactant is preferably added in an amount ranging between 0.1 and 30% by weight of the coating, more preferably between 0.5 and 20%, and most preferably between 1 and 15%.

### Top coat.

The coating may comprise a top layer which acts as an oxygen barrier layer, hereinafter also referred to as "overcoat layer" or "overcoat". Preferred binders which can be used in the top layer are polyvinyl alcohol and the polymers disclosed in WO-2005/029190, US 6,410,205 and EP 1 288 720, including the cited references in these patents and patent applications. The most preferred binder for the toplayer is polyvinylalcohol. The polyvinylalcohol has preferably a hydrolysis degree ranging between 74 mol % and 99 mol %. The weight average molecular weight of the polyvinylalcohol can be measured by the viscosity of an aqueous solution, 4 % by weight, at 20°C as defined in DIN 53 015, and this viscosity number ranges preferably between 3 and 26, more preferably between 3 and 15, most preferably between 3 and 10. The coating thickness of the top layer is preferably between 0.25 and 1.75 g/m², more preferably between 0.25 and 1.3 g/m², most preferably between 0.25 and 1.0 g/m². In a more preferred embodiment of the present invention, the toplayer has a coating thickness between 0.25 and 1.75 g/m² and comprises a polyvinylalcohol having a hydrolysis degree ranging between 74 mol % and 99 mol % and a viscosity number as defined above ranging between 3 and 26.

### Support.

A particularly preferred lithographic support is an electrochemically grained and anodized aluminum support. The aluminum support has a thickness of about 0.1-0.6 mm. However, this thickness can be changed appropriately depending on the size of the printing plate used and the plate-setters on which the printing plate precursors are exposed. Graining an anodizing of aluminum supports is well known. The acid used for graining can be e.g. nitric acid or sulfuric acid. The acid used for graining preferably comprises hydrogen chloride. Also mixtures of e.g. hydrogen chloride and acetic acid can be used. The relation between electrochemical graining and anodizing parameters such as electrode voltage, nature and concentration of the acid electrolyte or power consumption on the one hand and the obtained lithographic quality in terms of Ra and anodic weight (g/m² of Al₂O₃ formed on the aluminum surface) on the other hand is well known. More details about the relation between various production parameters and Ra or anodic weight can be found in e.g. the article "Management of Change in the Aluminium Printing Industry" by F. R. Mayers, published in the ATB Metallurgie Journal, volume 42 nr. 1-2 (2002) pag. 69.

Preferred anodic weights are between 0.5 and 10 g/m² of Al₂O₃, more preferably between 1 and 5 g/m² of Al₂O₃.

A preferred aluminum substrate, characterized by an arithmetical mean center-line roughness Ra less then 0.45 µm is described in EP 1 356 926.

The anodized aluminum support may be subject to a so-called post-anodic treatment to improve the hydrophilic properties of its surface. For example, the aluminum support may be silicated by treating its surface with a sodium silicate solution at elevated temperature, e.g. 95°C. Alternatively, a phosphate treatment may be applied which involves treating the aluminum oxide surface with a phosphate solution that may further contain an inorganic fluoride. Further, the aluminum oxide surface may be rinsed with a citric acid or citrate solution. This treatment may be carried out at room temperature or may be carried out at a slightly elevated temperature of about 30 to 50°C. A further interesting treatment involves rinsing the aluminum oxide surface with a bicarbonate solution. Still further, the aluminum oxide surface may be treated with polyvinylphosphonic acid, polyvinylmethylphosphonic acid, phosphoric acid esters of polyvinyl alcohol, polyvinylsulfonic acid, polyvinylbenzenesulfonic acid, sulfuric acid esters of polyvinyl alcohol, and acetals of polyvinyl alcohols formed by reaction with a sulfonated aliphatic aldehyde.

Another useful post-anodic treatment may be carried out with a solution of polyacrylic acid or a polymer comprising at least 30 mol% of acrylic acid monomeric units, e.g. GLASCOL E15, a polyacrylic acid, commercially available from ALLIED COLLOIDS.

Another treatment is the so-called sealing of the micropores as described in WO-2005/111717.

Optimizing the pore diameter and distribution thereof of the grained and anodized aluminum surface as described in EP 1 142 707 and US 6,692,890 may enhance the press life of the printing plate and may improve the resolution of the printing plate. Avoiding large and deep pores as described in US 6,912,956 may also improve the toning behaviour of the printing plate.

In the unpublished EP-A 06 110 468 (filed on 2006-02-28) a characterizing method of the surface of a grained and anodized aluminum is disclosed. The parameter 'mean pith depth', calculated according to this characterizing method, correlates with the number and depth of the pits present at the aluminum surface. The mean pith depth of the aluminum surface is preferably less then 2.0 µm, more preferably less then 1.8 µm, most preferably less then 1.5 µm. The standard deviation of the 'mean pith depth' is preferably less then 0.70, more preferably less then 0.50, most preferably less then 0.35.

The grained and anodized aluminum support may be a sheet-like material such as a plate or it may be a cylindrical element such as a sleeve which can be slid around a print cylinder of a printing press.

The support can also be a flexible support, which may be provided with a hydrophilic layer, hereinafter called 'base layer'. The flexible support is e.g. paper, plastic film or aluminum. Preferred examples of plastic film are polyethylene terephthalate film, polyethylene naphthalate film, cellulose acetate film, polystyrene film, polycarbonate film, etc. The plastic film support may be opaque or transparent. The base layer is preferably a crosslinked hydrophilic layer obtained from a hydrophilic binder crosslinked with a hardening agent such as formaldehyde, glyoxal, polyisocyanate or a hydrolyzed tetra-alkylorthosilicate. The latter is particularly preferred. The thickness of the hydrophilic base layer may vary in the range of 0.2 to 25 µm and is preferably 1 to 10 µm. More details of preferred embodiments of the base layer can be found in e.g. EP-A 1 025 992.

### Processing of the lithographic printing plate precursor

### Pre-heat.

The method as described in claim 1 optionally comprises a pre-heat step. In a pre-heat step, performed after image-wise exposure and before development, the plate precursor is heated to enhance or to speed-up the polymerization and/or crosslinking reaction. There is no particular time limit between exposure and pre-heat but the preheat step is usually carried out within a time period after exposure of less than 10 minutes, preferably less than 5 minutes, more preferably less than 1 minutes, most preferably the preheat is carried out immediately after the image-wise exposing, i.e. within less than 30 seconds. In this heating step, the precursor is heated at a temperature of preferably 80°C to 150°C and during a dwell time of preferably 5 seconds to 1 minute. The preheating unit is preferably provided with heating elements such as IR-lamps, UV-lamps, heated air, a heated metal roll, etc.

### Alkaline Developer.

Photopolymerizable printing plate precursors are, according to one embodiment of the present invention, developed in an alkaline aqueous solution. In the development step, the complete overcoat layer and the unexposed part of the photosensitive layer are removed. The removal (wash-off) of the overcoat layer and the development of the photosensitive layer can be done in two separate steps in this order, but can also be done in one step simultaneously. Preferably the overcoat layer is washed-off with water before the development step. The wash-off can be done with cold water, but it is preferred to use hot water to accelerate the process.

The developer solution preferably is an aqueous alkaline solution having a pH from 9 to 14, a pH from 11.5 to 13.5 being particularly preferred. The developer solution can contain a small percentage, preferably less than 5 wt.%, of an organic, water-miscible solvent. To adjust the pH of the solution, an alkali hydroxide is preferably used.

Examples of preferred, additional ingredients of the developer solution comprise alone or in combination alkali phosphates, alkali carbonates, alkali bicarbonates, an organic amine compound, alkali silicates, buffering agents, complexants, defoamers, surface active agents and dyes, as described in e.g. EP-A 1 273 972, EP-A 1 521 123, WO-2005/111717 and the unpublished EP-As 05 103 878 and 05 103 897 (both filed on 2005-05-10), but the suitable ingredients are not limited hereto and further ingredients can be used.

The method of development employed is not particularly limited, and may be conducted by immersing and shaking the plate in a developer, physically removing non-image portions while being dissolved in a developer by means of e. g. a brush, or spraying a developer onto the plate so as to remove non-image portions. The time for development is selected so that the non-image portions are adequately removed, and is optionally selected within a range of 5 seconds to 10 minutes. Development can be carried out at room temperature or at elevated temperatures, for example between 25 °C and 50 °C, more preferably between 25 °C and 40 °C.

### Gum solution.

In another preferred embodiment of this invention the developer used in the method as defined in claim 1 is a gum solution. A preferred composition of the gum solution to be used in the present invention is disclosed in W0-2005/111727 (page 5 to 11) and in the unpublished EP-A 05 110 943 (filed on 2005-11-18). Development with the gum solution can be performed at room temperature or at elevated temperatures, e.g. between 25 and 50 °C. Development can be carried on until the gum solution is exhausted and has to be replaced by a fresh gum solution or the gum solution is constantly regenerated by adding fresh gum solution as a function of the amount of printing plate precursors developed. The gum solution, used for regeneration, can be of the same or different, preferably higher, concentration. The development step of the method as defined in claim 1 may comprise a prewash step as disclosed in the unpublished EP-A 05 110 915 (filed on 2005-11-18). In this method development comprises washing the precursor in a prewashing station by applying water or an aqueous solution to the coating, thereby removing at least part of the toplayer, followed by development of the precursor in a gumming station by applying a gum solution to the coating of the precursor, thereby removing the non-exposed areas of the photopolymerizable layer from the support and gumming the plate in a single step. The development step of this invention may also comprise two gumming steps as disclosed in the unpublished EP-A 05 110 916 and EP-A 05 110 919 (both filed on 2005-11-19). EP-A 05 110 916 describes a development carried out in a gumming station, said gumming station comprises a first and at least a second gumming unit, wherein the precursor is washed in the first gumming unit by applying a gum solution to the coating, thereby removing at least part of the top layer, and wherein, subsequently, the precursor is developed in the second gumming unit with a gum solution, thereby removing non-exposed areas of the photo-polymerizable layer from the support and gumming the plate in a single step. EP-A 05 110 919 describes a development carried out in a gumming station, comprising a first and at least a second gumming unit, wherein the precursor is consecutively developed in said first and said second gumming unit with a gum solution, thereby removing non-exposed areas of the photopolymerizable layer from the support and gumming the plate in a single step.

### On press development.

In another preferred embodiment of this invention the development is carried out on press by applying ink and/or fountain to the image wise exposed printing plates. The non-exposed areas of the photopolymerizable layer is removed by dissolution or dispersion by the ink and/or the aqueous fountain solution while the exposed areas are substantially not removed by applying ink and/or fountain. Also for the on press development embodiment the photopolymerizable composition comprises preferably a polymer as described in the unpublished EP-A 05 110 943 and explained in detail above.

The processing of the invention as described in claim 1 may also be performed by combining the embodiments for development as described above, e.g. combining development with a gum solution with development on press by applying ink and/or fountain.

After development the printing plate may be subjected to several well known post-development treatments (e.g. drying, gumming, baking, etc.).

### EXAMPLES

### Example 1

### Comparative Example 1 (Comp.Ex.1)

### Preparation of the printing plate precursor

Components used in Comparative Example 1:
(A) A solution containing 32.4 wt.% of a methyl methacrylate / methacrylic acid-copolymer (ratio methylmethacrylate / methacrylic acid of 4:1 by weight; acid number: 110 mg KOH/g) in 2-butanone (viscosity 105 mm²/s at 25°C).
(B) A solution containing 88.2 wt.% of a reaction product from 1 mole of 2,2,4-trimethyl-hexamethylenediisocyanate and 2 moles of hydroxyethylmethacrylate (viscosity 3.30 mm²/s at 25°C).
(C) Mono Z1620, a solution in 2-butanone containing 30.1 wt.% of a reaction product from 1 mole of hexamethylenediisocyanate, 1 mole of 2-hydroxyethylmethacrylate and 0.5 mole of 2-(2-hydroxyethyl)-piperidine (viscosity 1.7 mm²/s at 25 °C).
(D) 1,4-distyryl-(3,5-trimethoxy, 4-(2-butyl)oxy)benzene.
(E) Heliogene blue D 7490® dispersion (9.9 wt.%, viscosity 7.0 mm²/s at 25 °C), trade name of BASF AG, as defined in EP 1 072 956.
(F) 2,2'-Bis(2-chlorophenyl)-4,4',5,5'-tetraphenyl-1,2-bisimidazole.
(G) 2-Mercaptobenzothiazole.
(H) Edaplan LA 411® (1 wt.% in Dowanol PM®, trade mark of Dow Chemical Company).
(I) 2-Butanone.
(J) Propyleneglycol-monomethylether (Dowanol PM®, trade mark of Dow Chemical Company).
(K) Partially hydrolyzed poly(vinyl alcohol) (degree of saponification 88 mol-%, viscosity 4 mPa•s in an aqueous solution of 4 wt.% at 20 °C).
(L) Fully hydrolyzed poly(vinyl alcohol) (degree of saponification 98 mol-%, viscosity 6 mPa•s in an aqueous solution of 4 wt.% at 20°C) .
(M) Partially hydrolyzed poly(vinyl alcohol) (degree of saponification 88 mol %, viscosity 8 mPa•s in an aqueous solution of 4 wt.% at 20 °C).
(N) Acticide LA1206; a biocide commercially available from Thor.
(O) Lupasol P is a solution of 50 % by weight in water of a polyethylene imine, commercially available from BASF
(P) Lutensol A8 (90 wt.%) (surface active agent commercially available from BASF)
(Q) Water

### Preparation and coating of the photopolymerizable composition

A composition was prepared (pw = parts per weight; wt.% = weight percentage) by mixing the ingredients as specified in table 1. This composition was coated on an electrochemically roughened and anodically oxidized aluminum sheet, the surface of which has been rendered hydrophilic by treatment with an aqueous solution of poly(vinyl phosphonic) acid (aluminum oxide weight = 3 g/m²) and was dried at 105 °C . The resulting thickness of the layer was 1.5 g/m².

**Table 1: Composition of the photopolymerizable coating solution**

| Component | Parts per weight (g) |
|---|---|
| (A) | 184.10 |
| (B) | 36.60 |
| (C) | 382.50 |
| (D) | 10.97 |
| (E) | 209.00 |
| (F) | 16.58 |
| (G) | 0.77 |
| (H) | 25.50 |
| (I) | 650.07 |
| (J) | 1489.95 |

### Preparation and coating of the top layer

On top of the photopolymerizable layer a solution in water of the composition as defined in table 2 was coated and then was dried at 120 °C for 2 minutes.

**Table 2: coating composition of the top layer**

| Component | Parts per weight (g) |
|---|---|
| (K) | 57.42 |
| (L) | 50.14 |
| (M) | 25.07 |
| (N) | 0.27 |
| (O) | 1.35 |
| (P) | 1.42 |
| (Q) | 2864.3 |

The top layer had a dry thickness of 1.75 g/m².

### Preparation of the printing plate

Imaging was carried out with a Galileo VS violet plate-setter device (internal drum system, available from Agfa Gevaert NV, Belgium) equipped with a violet laser diode (60 mW laser diode from Nichia, product code NDHV310APC, wavelength is 405 nm). The plate was imaged with different energy densities ranging from 20 up to 60 µJ/cm². A 169.7 lpi screen was imaged at 2400 dpi. The spinner speed was 37500 rpm corresponding to a pixel dwell time of 11 nanoseconds.

After imaging the plate was processed in a VSP-85 processor, commercially available from Agfa Gevaert NV, with the following settings:
- pre-heated at 110°C (measured at back of plate)
- 1.2 m/min
- developer: PL10, commercially available from Agfa Gevaert NV
- developer temperature : 24°C

After processing, the plate was mounted on a Heidelberg GTO52 printing press and a print job was started using K + E Novavit 800 Skinnex ink (trademark of BASF Drucksysteme GmbH) and Rotamatic as fountain liquid.

### Invention example 1 (Inv.Ex.1)

The imaging element as prepared in comparative example 1 was exposed with a violet external drum plate-setter device (two laser diodes of 60mW from Nichia (product code NDHV310APC), wavelength is 405nm, GLV optical system, 360 writing beams, spot size in the fast scan direction is 7.0 µm, spot size in the cross scan direction is 10.5 µm). The plate was imaged with different energy densities ranging from 42 up to 103 µJ/cm². A 169.7 lpi screen was imaged at 2400 dpi. The drum speed ranged from 79 rpm to 192 rpm corresponding to pixel dwell times ranging from 8.5 µs to 3.5 µs.

After imaging the plate was processed in a VSP-85 processor, commercially available from Agfa Gevaert NV, with the following settings:
- pre-heated at 110°C (measured at back of plate)
- 1.2 m/min
- developer: PL10, commercially available from Agfa Gevaert NV
- developer temperature: 24°C

After processing, the plate was mounted on a Heidelberg GTO52 printing press and a print job was started using K + E Novavit 800 Skinnex ink (trademark of BASF Drucksysteme GmbH) and Rotamatic as fountain liquid.

### Evaluation of Invention Example 1 and Comparative Example 1

The Optimum Exposure (O.E.) and the Optimum Screen Rendering (O.S.R.) on the exposed and developed plate and on the printed paper produced by this plate, at 169.7 lines per inch (lpi), was determined (see results in table 3). The Optimum Exposure is defined as the energy density at which the best rendition on plate of both the highlights (1-10 % dot coverage area) and the shadows (90 - 100 % dot coverage area) is realized. The Optimum Screen Rendering (O.S.R.) indicates to which extent the highlights and shadows can be accurately rendered at the Optimum Exposure. The dot gain, i.e. increase in dot coverage of a 50 % patch, was determined at the Optimum Exposure.

To determine the above described parameters, a digital microscope (Teckon DMS910) was used. An image is taken of the different patches, obtained with different exposures, on the precursor and on the printed paper. The image is digitalized and the dot coverage of the different patches is calculated as well as the Optimum Exposure and Optimum Screen Rendering, as defined above.

**Table 3: image quality of Comp. Ex. 1 and Inv. Ex. 1**

| | exposure mode | O.E. (µJ/cm²) | O.S.R. on plate | O.S.R. on print | dot gain |
|---|---|---|---|---|---|
| Comparative Example 1 | ITD | 29 | 2 - 97 % | 2 - 90 % | 8.7 |
| Invention Example 1 | XTD | 65 | 1 - 98 % | 1 - 95 % | 6.8 |

It is clear from table 3 that the Optimum Screen Rendering achievable at 169.7 lpi is larger for the invention example 1 as compared to the comparative example 1, as well on plate as on paper. In addition, the invention example 1 is characterized by less dot gain at the Optimum Exposure compared to the comparative example 1.

### Example 2

### Comparative Example 2 (Comp.Ex.2)

### Preparation of the printing plate precursor

Components used in Comparative Example 2:
(A) KOMA30 - esterification of a copolymer of [vinyl butyralvinylalcohol and vinylacetate] with trimellit acid anhydride available from Clariant (14,3% w/w: in Dowanol PM)
(B) A solution containing 88.2 wt.% of a reaction product from 1 mole of 2,2,4-trimethyl-hexamethylenediisocyanate and 2 moles of hydroxyethylmethacrylate (viscosity 3.30 mm²/s at 25°C).
(C) Mono Z1620, a solution in 2-butanone containing 30.1 wt.% of a reaction product from 1 mole of hexamethylenediisocyanate, 1 mole of 2-hydroxyethylmethacrylate and 0.5 mole of 2-(2-hydroxyethyl)-piperidine (viscosity 1.7 mm²/s at 25 °C).
(D) 1,4-distyryl-(3,5-trimethoxy, 4-(2-butyl)oxy)benzene.
(E) Heliogene blue D 7490® dispersion (9.9 wt.%, viscosity 7.0 mm²/s at 25 °C), trade name of BASF AG, as defined in EP 1 072 956.
(F) 2,2'-Bis(2-chlorophenyl)-4,4',5,5'-tetraphenyl-1,2-bisimidazole.
(G) 2-Mercaptobenzothiazole.
(H) Edaplan LA 411® (1 wt.% in Dowanol PM®, trade mark of Dow Chemical Company).
(I) 2-Butanone.
(J) Propyleneglycol-monomethylether (Dowanol PM®, trade mark of Dow Chemical Company).
(K) Partially hydrolyzed poly(vinyl alcohol) (degree of saponification 88 mol-%, viscosity 4 mPa•s in an aqueous solution of 4 wt.% at 20 °C).
(L) Fully hydrolyzed poly(vinyl alcohol) (degree of saponification 98 mol-%, viscosity 6 mPa•s in an aqueous solution of 4 wt.% at 20°C) .
(M) Partially hydrolyzed poly(vinyl alcohol) (degree of saponification 88 mol %, viscosity 8 mPa**•**s in an aqueous solution of 4 wt.% at 20 °C).
(N) Acticide LA1206; a biocide commercially available from Thor.
(O) Lupasol P is a solution of 50 % by weight in water of a polyethylene imine, commercially available from BASF
(P) Lutensol A8 (90 wt.%) (surface active agent commercially available from BASF)
(Q) Water
(R) N,N dimethylaminopropylmethacrylamide

### Preparation and coating of the photopolymerizable composition

A composition was prepared (pw = parts per weight; wt.% = weight percentage) by mixing the ingredients as specified in table 4. This composition was coated on an electrochemically roughened and anodically oxidized aluminum sheet, the surface of which has been rendered hydrophilic by treatment with an aqueous solution of poly(vinyl phosphonic) acid (aluminum oxide weight 3 g/m²) and was dried at 105 °C . The resulting thickness of the layer was 1.2 g/m².

**Table 4: Composition of the photopolymerizable coating solution**

| Component | Parts per weight (g) |
|---|---|
| (A) | 102.23 |
| (B) | 12.07 |
| (C) | 127.50 |
| (D) | 3.66 |
| (E) | 69.96 |
| (F) | 5.53 |
| (G) | 0.26 |
| (H) | 0.85 |
| (I) | 166.97 |
| (J) | 503.00 |
| (R) | 4.94 |

### Preparation and coating of the top layer

On top of the photopolymerizable layer a solution in water of the composition as defined in table 5 was coated and then was dried at 120 °C for 2 minutes.

**Table 5: coating composition of the top layer**

| Component | Parts per weight (g) |
|---|---|
| (K) | 57.42 |
| (L) | 50.14 |
| (M) | 25.07 |
| (N) | 0.27 |
| (O) | 1.35 |
| (P) | 1.42 |
| (Q) | 2864.3 |

The top layer had a dry thickness of 1.75 g/m².

### Preparation of the printing plate

The imaging was carried out with a Galileo VS violet plate-setter device (internal drum system, available from Agfa Gevaert NV, Belgium) equipped with a violet laser diode (60 mW laser diode from Nichia, product code NDHV310APC, wavelength is 405 nm). The plate was imaged with different energy densities ranging from 11 up to 37 µJ/cm². A 169.7 lpi screen was imaged at 2400 dpi. The spinner speed was 37500 rpm corresponding to a pixel dwell time of 11 nanoseconds.

After image-wise exposing, the precursors were pre-heated by transporting the precursor through the pre-heating unit of a VSP-85, commercially available from Agfa Gevaert NV, at a speed of 1.2 m/min. The temperature, measured on the back side of the plate precursor was 110°C.

After the pre-heat, the precursors were developed in a gumming unit comprising a brush roller by using solution Gum-1, prepared as follows:
To 750 g demineralised water
100 ml of Dowfax 3B2 (commercially available from Dow Chemical)
31.25 g 1,3-benzene disulphonic acid disodium salt (available from Riedel de Haan)
31.25 ml Versa TL77 (a polystyrene sulphonic acid available from Alco Chemical)
10.4 g trisodium citrate dihydrate,
2 ml of Acticide LA1206 (a biocide from Thor),
2.08 g of Polyox WSRN-750 (available from Union Carbide) were added under stirring and demineralised water was further added to 1000 g.

After gum processing, the plates were mounted on a Heidelberg GTO52 printing press and a print job was started using K + E Novavit 800 Skinnex ink (trademark of BASF Drucksysteme GmbH) and Rotamatic as fountain liquid.

### Invention example 2 (Inv.Ex.2)

The imaging element, as prepared in Comparative Example 2, was exposed with a violet external drum plate-setter device (two laser diodes of 60mW from Nichia (product code NDHV310APC), wavelength is 405 nm, GLV optical system, 360 writing beams, spot size in the fast scan direction is 7.0 µm, spot size in the cross scan direction is 10.5 µm). The plate was imaged with different energy densities ranging from 28 up to 66 µJ/cm². A 169,7 lpi screen was imaged at 2400 dpi. The drum speed ranged from 120 rpm to 240 rpm corresponding to a pixel dwell times ranging from 5.6 to 2.8 µs.

After image-wise exposing, the precursors were pre-heated by transporting the precursor through the pre-heating unit of a VSP-85 (available from Agfa Gevaert) at a speed of 1.2 m/min. The temperature, measured on the back side of the plate precursor, was 110°C.

After the pre-heat the precursors were developed in a gumming unit comprising a brush roller by using solution Gum-1, defined above.

After gum processing, the plates were mounted on a Heidelberg GTO52 printing press and a print job was started using K + E Novavit 800 Skinnex ink (trademark of BASF Drucksysteme GmbH) and Rotamatic as fountain liquid.

### Evaluation of Invention Example 2 and Comparative Example 2

The evaluation of the printing plates has been performed as described in example 1. The results of the evaluation are shown in table 6.

**Table 6: image quality of Comp.Ex.2 and Inv.Ex.2**

| | Exposure mode | O.E. (µJ/cm) | O.S.R. on plate | O.S.R. on print | Dot gain |
|---|---|---|---|---|---|
| Comparative example 2 | ITD | 23 | 2 - 97 % | 2 - 90 % | 9.4 |
| Invention Example 2 | XTD | 52 | 1 - 98 % | 1 - 95 % | 7.4 |

It is clear from table 6 that the Optimum Screen Rendering achievable at 169.7 lpi is larger for the invention example 2 as compared to the comparative example 2, as well on plate as on paper. In addition, the invention example 2 is characterized by less dot gain at the Optimum Exposure compared to the comparative example 2.

### Example 3

### Comparative Example 3 (Comp.Ex.3)

The exposure latitude of the imaging element, as described in comparative example 2, was determined on the Galileo VS violet plate-setter device (internal drum system, available from Agfa Gevaert NV) equipped with a violet laser diode (60 mW laser diode from Nichia, product code NDHV310APC, wavelength is 405 nm). The plate was imaged with different energy densities (E) ranging from - 0.30 log E up to + 0.30 log E vs the optimum exposure as defined in the comparative example 2. A 169,7 lpi screen was imaged at 2400 dpi. The spinner speed was 37500 rpm corresponding to a pixel dwell time of 11 nanoseconds. The plate was developed as described for the comparative example 2.

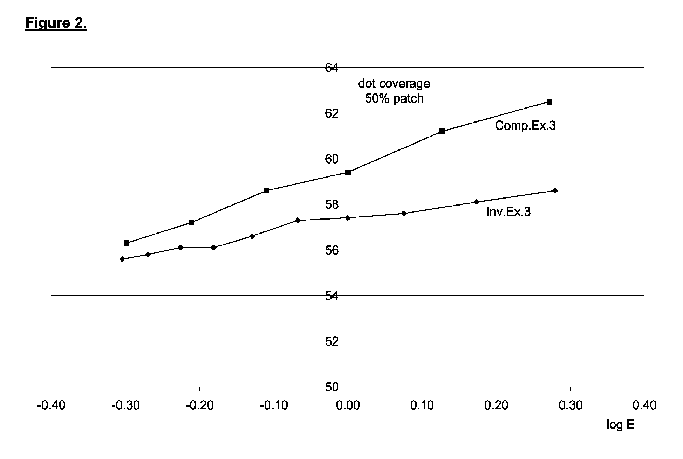

The dot coverage on the printing plate of the 50 % patch at 169,7 lpi was measured and plotted against the energy densities (E) ranging form - 0.30 log E up to + 0.30 Log E versus intensity of the optimum exposure (figure 2).

### Invention Example 3 (Inv.Ex.3)

The exposure latitude of the imaging element, as described in invention example 2, was determined on a violet external drum plate-setter device (two laser diodes of 60mW from Nichia (product code NDHV310APC), GLV optical system, 360 writing beams, spot size in the fast scan direction is 7.0 µm, spot size in the cross scan direction is 10.5 µm). The plate was imaged with different energy densities (E) ranging from -0.30 log E up to + 0.30 log E vs the optimum exposure as defined in the invention example 2. A 169,7 lpi screen was imaged at 2400 dpi. The drum speed was 240 rpm corresponding to a pixel dwell time of 2.8 µs. The plate was developed as described for the invention example 2.

In figure 2, the dot coverage on the printing plate of the 50 % patch at 169.7 lpi (Y-axis) is plotted against the energy densities (E) ranging form - 0.30 log E up to + 0.30 Log E versus intensity of the optimum exposure (X-axis). It is clear from figure 2 that the dot coverage on the printing plate is less dependent on the exposure intensity for the invention example 3 compared to the comparative example 3, resulting in a more reliably exposure system. Form this figure it is also clear that the dot gain (increase in dot coverage of a 50 % patch) is substantially less for the invention example 3 compared to the comparative example, at the optimum exposure.

## Claims

1. A method for making a lithographic printing plate comprising the steps of:
- providing a printing plate precursor comprising a support and an photosensitive coating wherein said photosensitive coating comprises a photopolymerizable composition;
- image wise exposing said printing plate precursor on an external drum apparatus emitting one or more scanning laser beams having a wavelength between 390 and 420 nm and an energy density, measured on the surface of the precursor, of 100 µJ/cm² or less.
- optionally pre-heating said printing plate precursor;
- processing said exposed printing plate precursor with a developer.

2. A method according to claim 1 wherein the scanning laser beam(s) has a pixel dwell time between 0.5 and 10 microseconds.

3. A method according to any of the preceding claims wherein the external drum apparatus comprises a GLV or DMD modulation element.

4. A method according to any of the preceding claims wherein the scanning laser beam(s) has a spot size in the fast scan direction between 2.5 and 25 microns.

5. A method according to any of the preceding claims wherein the external drum apparatus has a contrast ratio greater then 250.

6. A method according to any of the preceding claims wherein the developer is an alkaline solution having a pH between 9 and 14.

7. A method according to any of the preceding claims wherein the developer is a gum solution.

8. A method according to claims 1 to 4 wherein the process step is carried out on press by supplying ink and/or fountain solution to the exposed printing plate precursor.

9. A method according to any of the preceding claims wherein the photopolymerizable composition comprises a sensitizer capable of absorbing light with a wavelength between 390 and 420 nm.

10. A method according to any of the preceding claims wherein the precursor further comprises a top layer.

11. A method according to any of the preceding claims wherein the support of the precursor is a grained and anodized Aluminum support of which the surface is **characterized by** a mean pith depth less then 2.0 microns.
